# EUROPEAN PATENT APPLICATION

(11) **EP 1 867 912 A1**
(43) Date of publication of application: **19.12.2007**
(21) Application number: 06715309.8
(22) Date of filing: 06.03.2006
(51) Int. Cl.: F21S 8/10, F21V 19/00, F21Y 101/02

(54) **LED LIGHTING DEVICE**

(30) Priority: 07.03.2005 JP 2005062146
(71) Applicant: The Furukawa Electric Co., Ltd., Chiyoda-ku Tokyo 100-8322 (JP)
(72) Inventor: ENOMOTO, Noritsugu, hi 2-chome, Chiyoda-ku, Tokyo 100-8322 (JP); UTSUNOMIYA, Hirofumi, hi 2-chome, Chiyoda-ku, Tokyo 100-8322 (JP); MOTOMURA, Shigeki, hi 2-chome, Chiyoda-ku, Tokyo 100-8322 (JP)
(74) Representative: Böck, Bernhard
(86) International application number: PCT/JP2006/304289
(87) International publication number: WO 2006/095692

(57) **Abstract**

An LED lighting device provided with a flat circuit body where LEDs are mounted in a lamp room that is constructed from a lamp body and a lens installed on a front opening of the lamp body, and with a reflector structure body for reflecting light that is emitted from the LEDs. Opening are formed in a wall section of the reflector structure body, and the LEDs of the flat circuit body are installed in the openings. As a result, the flat circuit body supported by the reflector structure body.

## Description

### FIELD OF THE INVENTION

The present invention relates to an LED lighting device with a plurality of LEDs (light-emitting diodes) installed therein as a light source.

### BACKGROUND OF THE INVENTION

An LED lighting device with a plurality of light-emitting diodes installed therein is used in a vehicle lamp positioned in the front end portion or the rear end portion of the vehicle. There is disclosed an LED lighting device in which partition boards (as supporting bases) are provided in a stepped configuration (in a three-dimensional fashion) within a lamp body as a part thereof, the supporting bases respectively support a board on which a plurality of light-emitting diodes are mounted with a prescribed interval and a bus bar circuit to supply electricity to the light-emitting diodes connected thereto by soldering is formed, and the respective bus bar circuits on the boards interconnected by lead wires are connected to a switch-control circuit (refer to the patent document 1, listed below).

The above described LED lighting device requires a specific type of the board suitable for the configuration of the light-emitting diodes, and the supporting bases, in addition to complicated workings such as connecting the light-emitting diodes to the bus bar circuit, interconnecting the bus bar circuits or the like. In order to reduce the above described problem, there is disclosed an LED lighting device in which a flat circuit body such as a flexible flat cable (FFC) with a plurality of LEDs mounted with a prescribed interval is three-dimensionally bent and supported on a supporting base installed in a stepped configuration within the lamp body (refer to the patent document 2, listed below).

Patent document 1: Utility Model publication Hei 6(1994)-56912
Patent document 2: Utility Model publication Hei 5(1993)-25749

### DISCLOSURE OF THE INVENTION

### PROMLEMS TO BE SOLVED BY THE INVENTION

According to the LED lighting device using the flat circuit body disclosed in the patent document 2, it is easier to support LEDs while adjusting respective positions of the LEDs so as to meet the prescribed configuration of the LEDs, compared with the LED lighting device using the board as disclosed in the patent document 1, thus enabling to expand the possibility of the design. However, since it is necessary to support the flat circuit body on the support base in the LED lighting device of the patent document 2, the construction of the LED lighting device becomes complicated, the downsizing thereof is not realized, and the manufacturing cost is hardly lowered.

An object of the present invention is to provide a downsized LED lighting device with simple construction, manufactured at low cost.

### MEANS TO SOLVE THE PROBLEM

The first embodiment of the LED lighting device of the invention is an LED lighting device including a lamp housing formed by a lamp body and a lens installed in a front opening of the lamp body, a flat circuit body with a plurality of LEDs mounted thereon, and a reflector for reflecting lights generated by the LEDs, both of which are installed within said lamp housing,
wherein a plurality of opening portions are formed in a wall portion of said reflector, and said LEDs of the flat circuit body are fixed into the respective opening portions such that the flat circuit body is supported by the reflector.
In the second embodiment of the LED lighting device of the invention, said reflector includes the wall portion positioned to face the lens, LED-fixing holes through which the respective LEDs of the flat circuit body are inserted, an engaging portion formed to be a tapered shape which defines the plurality of opening portions in the wall portion and communicates to the LED-fixing holes, each of the plurality of LEDs mounted on the flat circuit body being fixed onto the reflector in such manner that the LED is protruded through the LED-fixing hole into the opening portion defined by the engaging portion.
In the third embodiment of the LED lighting device of the invention, a reflecting body is further arranged on a side of the engaging portion which faces the opening portion.
In the fourth embodiment of the LED lighting device of the invention, said reflector includes the wall portion positioned to face the lens, an engaging portion formed to be a tapered shape which defines the plurality of opening portions in the wall portion, and a socket engaging portion to engage a socket in a lower end of the engaging portion, a socket receiving the LED and having a hole through which the light generated by the LED passes, being installed at a position of the flat circuit body on which the LED is mounted, and the socket being engaged in the socket engaging portion of the reflector, thus the LED of the flat circuit body is fixed in the opening portion of the reflector.
In the fifth embodiment of the LED lighting device of the invention, a bent portion is formed between the adjacent LEDs on the flat circuit body.
In the sixth embodiment of the LED lighting device of the invention, the socket engaging portion of the reflector includes a ring-like engaging projection on an outer surface thereof, and the socket includes a ring-like engaged projection corresponding to the engaging projection, the engaging projection and the engaged projection being fitted so that the LED on the flat circuit body is fixed on the reflector.
In the seventh embodiment of the LED lighting device of the invention, the socket comprises a box-like socket body receiving the LED, and a cover fixed to the socket body to hold the flat circuit body at a portion adjacent the LED together with the socket body, said hole portion being provided in the socket body so that an inner space of the socket body receiving the LED is communicated with the opening portion.

### EFFECT OF THE INVENTION

According to the LED lighting device of the invention, since the flat circuit body is supported on the reflector, the support base is not required. Thus, the number of the parts necessary for the LED lighting device is reduced, and the structure of the LED lighting device becomes simple, leading to downsizing and low manufacturing cost. Since the flat circuit body has flexibility, the flat circuit body can be supported in such manner as to meet the configuration of the reflector. In addition, the LEDs can be properly and swiftly installed in the opening portion of the reflector, thus the assembling of the LED lighting device becomes simple to improve efficiency in the manufacturing thereof.

Furthermore, according to the LED lighting device of the invention, since the socket is engaged to the reflector such that the LED on the flat circuit body is fixed through the socket to the opening portion of the reflector, the flat circuit body can be firmly and stably supported on the reflector. Thus, the assembling of the LED lighting device becomes more simple to improve efficiency in the manufacturing thereof. Furthermore, since the flat circuit body is supported on the reflector through the socket, the flat circuit body can be easily removed for detachment, and the maintenance thereof becomes easy.

Furthermore, according to the LED lighting device of the invention, since a pair of the bent portions are formed between the adjacent LEDs on the flat circuit body, the flat circuit body can be easily extended or/and shortened. Thus, the LED on the flat circuit body can be more easily fixed to the opening portion of the reflector so that the workability in assembling the LED lighting device can be remarkably improved.

### BRIEF DESCRIPTION OF THE DRAWINGS

Fig. 1 is a schematic frontal view of one embodiment of the LED lighting device of the invention adapted to a lamp device in the rear portion of the vehicle;
Fig. 2 is a cross-sectional view cut along the X-X line as shown in Fig. 1;
Fig. 3 is a cross-sectional view cut along the X-X line as shown in Fig. 1;
Fig. 4A is a plan view of the flat circuit body mounting LED in the LED lighting device;
Fig. 4B is a frontal view of the flat circuit body mounting LED in the LED lighting device;
Fig. 4C is a cross-sectional view cut along the Y-Y line in Fig. 4B;
Fig. 5A is a frontal view of the thrust-through type connector used in the flat circuit body depicted in Figs. 4A to 4C;
Fig. 5B is a side view of the thrust-through type connector used in the flat circuit body depicted in Figs. 4A to 4C;
Fig. 6 is a cross-sectional view of the other embodiment of the LED lighting device of the invention;
Fig. 7 is a perspective view of a modified example of the flat circuit body as depicted in Figs. 4A to 4C;
Fig. 8A is a side view of the flat circuit body with a curved portion between the LEDs;
Fig. 8B is a side view of the flat circuit body with a U-shaped curved portion provided between the adjacent two bent portions 41a;
Fig. 8C is a side view of an example of the flat circuit body with three bent portions 41a provided; and
Fig. 8D is a side view of other example of the flat circuit body with three bent portions provided.

### DESCRIPTION OF NUMERAL REFERENCE

- 1: lamp body
- 3: lens
- 5: lamp housing
- 7, 41: flat circuit body
- 9: LED
- 11: reflector
- 11a: wall portion
- 11b: reflecting body
- 13: opening portion
- 15, 31: engaging portion
- 15a: LED-fixing hole
- 17: flat conductor
- 19: insulating sheath
- 21: connector
- 23: plate-shaped lead
- 25: thrusting teeth
- 27: socket
- 29: hole portion
- 33: socket body
- 35: cover
- 37, 39: engaged projection, engaging projection
- 41a: bent portion

### MOST PREFERABLE EMBODIMENT TO PERFORM THE INVENTION

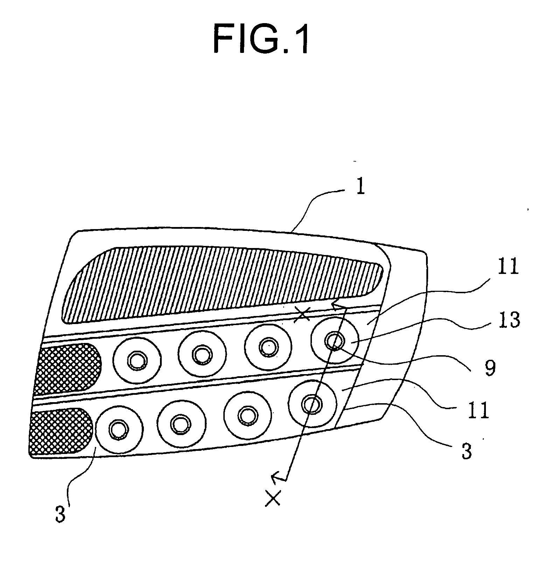

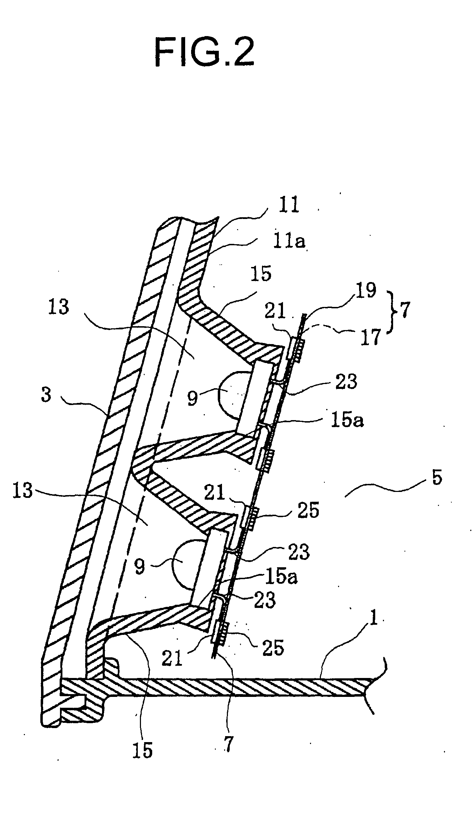

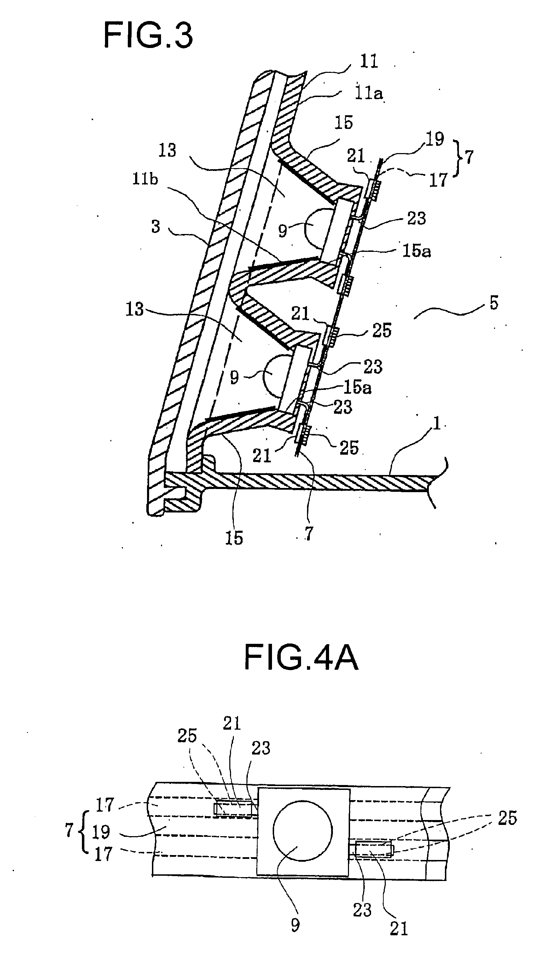

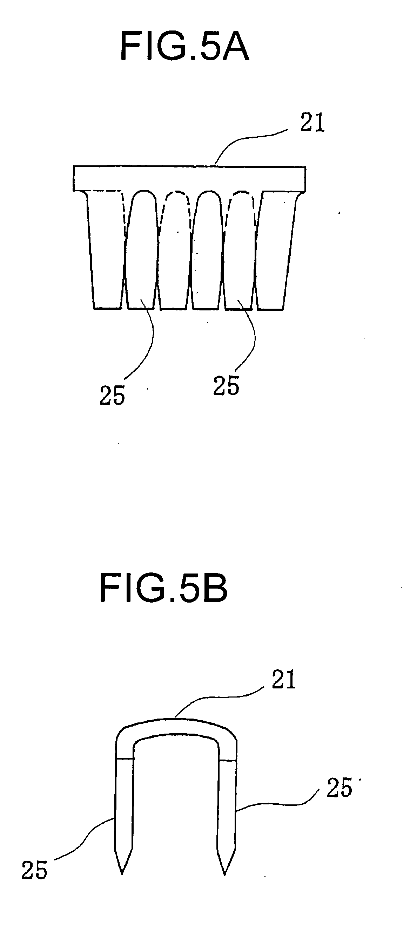

Various embodiments of the present invention are described in detail with reference to the drawings. Fig. 1 is a schematic frontal view of one embodiment of the LED lighting device of the invention adapted to a lamp device in the rear portion of the vehicle. Fig. 2 is a cross-sectional view cut along the X-X line as shown in Fig. 1. Fig. 3 is a cross-sectional view cut along the X-X line as shown in Fig. 1, the embodiment of which includes a reflecting body. Fig. 4A to Fig. 4C show a flat circuit body in the LED lighting device as shown in Fig. 1. Fig. 5A and Fig. 5B show a thrust-through type connector used in the flat circuit body as shown in Fig. 4A to Fig.4C.

In the embodiment of the LED lighting device, a flat circuit body 7 with a plurality of LEDs 9 mounted thereon, and a reflector 11 for reflecting the light generated by the LEDs 9 are installed within a lamp housing 5 formed by a lamp body 1 and a lens fixed in a front opening of the lamp body 1, as depicted in Figs. 1 and 2. The lamp body 1, the lens 3 and the reflector 11 are made of material such a synthetic resin as polypropylene, acrylonitrile-styrene acrylate (ASA), and others used for a substrate. Talc or the like may be mixed into the material in order to increase the rigidity thereof. Thus prepared reflector 11 is inclined to be arranged at the back side of the lens with a space therebetween, and fixed to the lamp body 1

A plurality of opening portions 13 for example circular holes are formed in a wall portion 11a of the reflector 11. An engaging portion (i.e., the slanted wall portion defining the opening portion 13) is integrally formed with the wall portion 11a on the opposite side of the lens 3 in the opening portion 13, which engaging portion is formed to be trumpet-like (i.e., truncated cone, tapered in cross section), getting smaller in diameter toward the tip end thereof. An LED-fixing hole 15a is arranged in the tip portion of the engaging portion 15 through which the LED 9 on the flat circuit body 7 is inserted so that the LED 9 is fixed in the opening portion 13 of the reflector 11.

As depicted in Fig. 3, a reflecting body 11b for reflecting the light generated by the LED 9 may be formed on at least a portion forming the opening portion 13 of the engaging portion 15 in the reflector 11. The reflecting body 11b is formed by a metal plate or a plated metal thin film attached onto the engaging portion 15 in the reflector 11.

Furthermore, at least a portion on the engaging portion forming the opening portion 13 in the reflector 11 as depicted in Fig. 3 may be formed by a material having reflecting property. As the material having the reflecting property, a material with thermoplastic polyester finely foamed is available (for example, refer to Japanese Patent Application Publication No. 2000-56715).

The flat circuit body 7 comprises a flat cable having flexibility, for example a flexible flat cable (hereinafter referred to FFC) and a plurality of LEDs 9 mounted thereon with a specific interval along the longitudinal direction thereof. The FFC has two flat conductors 17 arranged in parallel and entirely covered with an insulating sheath 19, for example as depicted in Fig. 4A. The FFC is used as smoothly shaped, bent, folded, or the like. The flat conductor comprises a copper tape having a thickness of 0.15.mm, a width of 5.2 mm, for example, and the insulating sheath 19 comprises a polyethylene terephthalate film. Each LED 9 is mounted so as to straddle the two flat conductors 17. In place of the above described FFC, a flexible flat wiring material such as a flexible printed circuit board (FPC) may be used as the flat circuit body 7.

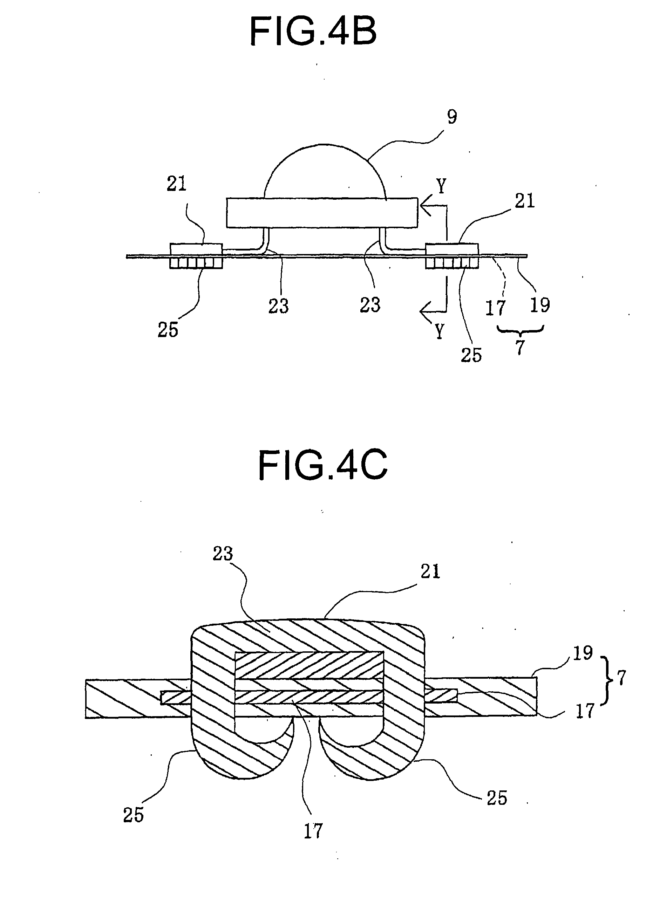

The flat circuit body 7 is connected to the LED 9 as depicted in Fig. 4B and Fig. 4C. More specifically, the plate-shaped lead 23 is placed directly on the flat conductor 17 of the flat circuit body 7 without removing the insulating sheath 19. Then, a thrust-through type connector 21 with triple thrusting teeth arranged in zigzag on both end thereof straddles the plate-shaped lead 23 as depicted in Fig. 5A and Fig. 5B, and the thrusting teeth 25 thrust through the flat conductor 17. The tip portion of the thrusting teeth are bent inward and caulked at the back side of the flat circuit body, thus the LED is connected to the flat circuit body. With this arrangement, the plate-shaped lead is firmly connected to the flat conductor 17 by the connector 21, thus obtaining an excellent electrical connection. In addition, the heat transfer from the plate-shaped lead 23 to the flat conductor 17 becomes flawless to improve the heat dissipation from the flat circuit body, thus controlling the temperature rise at the connecting portion.

The LED 9 on the flat circuit body 7 is inserted into the corresponding LED-fixing hole in the engaging portion 15 of the reflector 11 such that the flat circuit body 7 is supported on the back side of the reflector 11.

According to the LED lighting device of the invention, as described in the above embodiment, since the flat circuit body 7 is supported on the reflector 11, the support base as disclosed in the prior art is not required. Thus, the number of the parts necessary for the LED lighting device is reduced, and the structure of the LED lighting device becomes simple, leading to downsizing and low manufacturing cost. Furthermore, since the flat circuit body 7 has flexibility, the flat circuit body 7 can be supported in such manner as to meet the configuration of the reflector 11. In addition, the LEDs 9 can be properly and swiftly installed in the opening portion 13 of the reflector 11, thus the assembling of the LED lighting device becomes simple to improve efficiency in the manufacturing thereof.

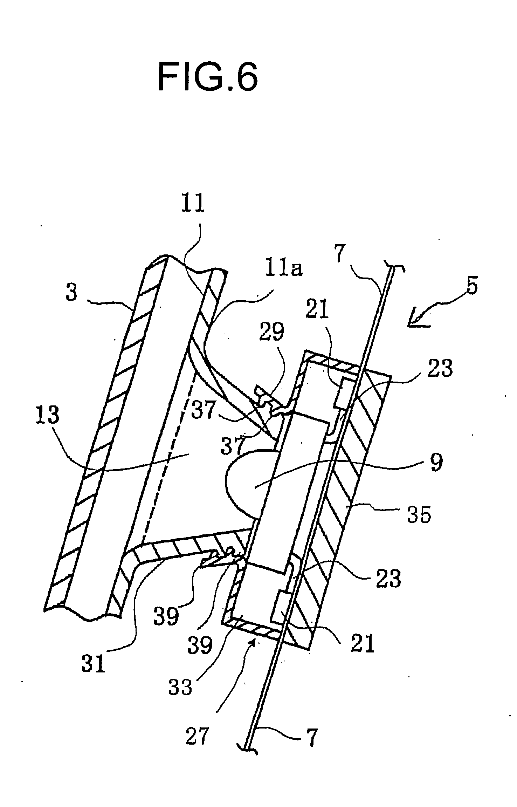

Fig. 6 shows one of other embodiment of the LED lighting device of the invention. In this embodiment, a socket 27 containing the LED and having a hole portion 29 through which a light generated by the LED 9 passes is installed at a portion corresponding to the LED 9 mounted on the flat circuit body 7. An engaging portion 31 is provided at the back side of the wall portion 11a which defines the opening portion 13 of the reflector 11. The socket 27 is engaged with the reflector 11 such that the LED 9 mounted on the flat circuit body 7 is fixed in the opening portion 13 of the reflector 11.

More specifically, the socket 27 comprises a box-like socket body 33 containing the LED 9 and a cover 35 which is to be attached to the socket body 33 so that the flat circuit body 7 mounting the LED 9 is sandwiched between the socket body 33 and the cover 35. The hole portion 29 communicating to the inner space containing the LED 9 is provided at the socket body 33 so as to match the outer surface of the engaging portion. In other words, the hole portion 29 is formed so as to expand its diameter from the bottom portion thereof (i.e., upper surface of the socket body) toward the tip end thereof like a truncated cone along the outer surface of the engaging portion. In addition, two ring-like engaged projections are formed on the inner surface of the hole portion 29.

On the other hand, the engaging portion 31 is integrally formed to define the opening portion 13 with the wall portion 11a, protruding toward the back side of the wall portion 11a of the reflector 11 in such manner that the diameter is gradually reduced toward the end thereof like the truncated cone. Two ring-like engaging projections 39 are formed on the outer surface of the tip end of the engaging portion 31.

The tip end of the engaging portion 31 defining the opening portion 13 of the reflector 11 is inserted into the hole portion 29 of the socket 27 to fit the engaging projections 39 into the engaged projections 37. The socket 27 is thus fixed onto the reflector 11 such that the LED 9 on the flat circuit body 7 is detachably fixed in the opening portion 13 of the reflector 11. More specifically, the flat circuit body 7 is detachably supported on the back side of the reflector 11. The remaining features are the same as described with reference to Figs. 1 to 5B, the description thereof is not repeated.

According to the LED lighting device as depicted in Fig. 6, since the socket 27 is engaged to the reflector 11 such that the LED 9 on the flat circuit body 7 is fixed through the socket 27 in the opening portion 13 of the reflector 11, the flat circuit body 7 can be firmly and stably supported on the reflector 11. Thus, the assembling of the LED lighting device becomes more simple to improve efficiency in the manufacturing thereof. Furthermore, since the flat circuit body 7 is supported on the reflector 11 through the socket 27, the flat circuit body 7 can be easily removed for repair, and the maintenance thereof becomes easy.

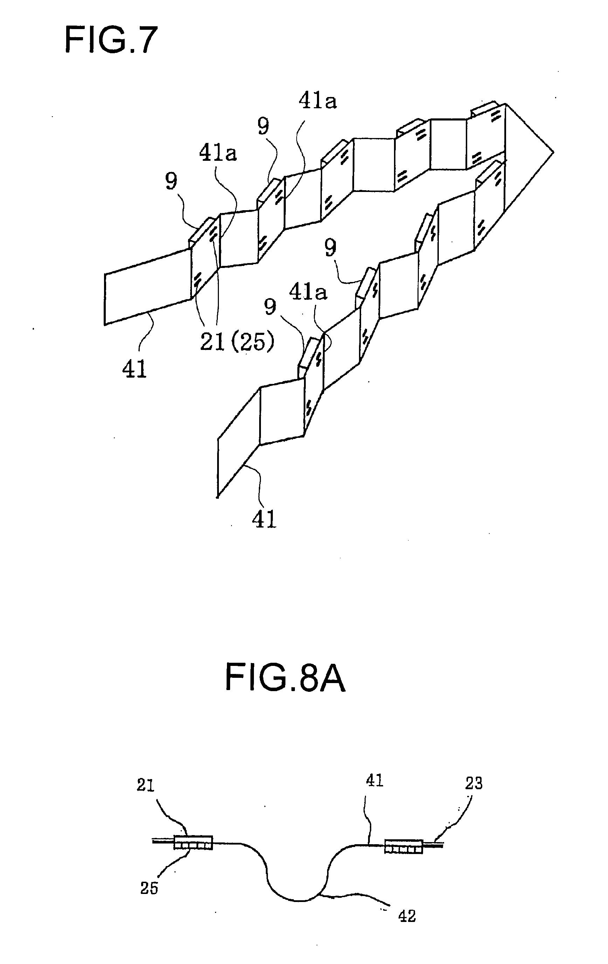

Fig. 7 shows a modified example of the flat circuit body as depicted in Figs. 4A to 4C. The flat circuit body 41 differs from the flat circuit body 7 as depicted in Fig. 2 in that a plurality pairs of bent portions 41a are formed between the adjacent LEDs 9, each pair of which comprises two bent portions bent in reverse directions each other. The remaining features are the same as those in the flat circuit body 7.

Since a pair of the bent portions 41a are formed between the adjacent LEDs 9 on the flat circuit body 41, the flat circuit body 41 can be easily extended or/and shortened. Thus, the LED 9 on the flat circuit body 41 can be more easily fixed in the opening portion 13 of the reflector 11 so that the workability in assembling the LED lighting device can be remarkably improved.

It is preferable that a stress is prevented from being applied on a connecting portion of the flat circuit body 41 including the connector 21 and the thrusting teeth 25, when the bent portion 41a is formed. In more detail, the bent portion 41a is formed apart from the connecting portion of the flat circuit body 41, or a folding line is formed in advance in an area in which the bent portion is to be formed and then the bent portion 41a is formed along the folding line.

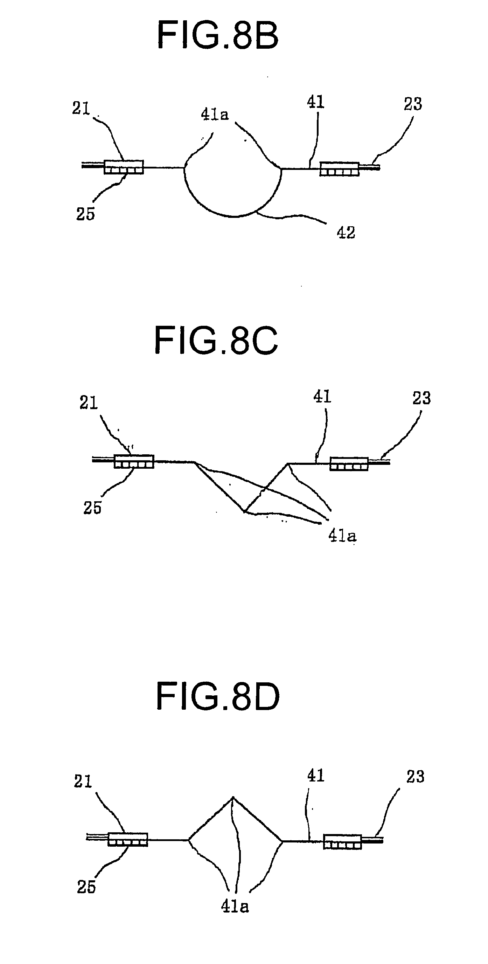

The configuration of the bent portion between the adjacent LEDs 9 in the flat circuit body 41 as depicted in Fig. 7 may be modified as follows, for example. Figs. 8A to 8D show other modified examples of the bent portion between the adjacent LEDs in the flat circuit body 41. Fig. 8A is a side view of the flat circuit body with a curved portion 42. Fig. 8B is a side view of the flat circuit body with a U-shaped curved portion 42 provided between the adjacent two bent portions 41a. Fig. 8C is a side view of an example of the flat circuit body with three bent portions 41a provided. Fig. 8D is a side view of other example of the flat circuit body with three bent portions provided. The surface of the flat circuit body on which the LED is mounted is the upper side face in the respective Figs. 8A to 8D.

Figs. 8A to 8C depict examples in which the bent portion or curved portion is formed opposite side of the surface on which the LED is mounted. Fig. 8D depicts an example in which the bent portion or curved portion is formed on the same side as the surface on which the LED is mounted. However, the side on which the bent portion or curved portion is formed is appropriately selected in accordance with the configuration of the reflector 11 to which the LED on the flat circuit body 41 is fixed. More specifically, the curved portion as depicted in Fig. 8A or 8B may be formed on the same side as the surface on which the LED is mounted. In addition, the number of the bent portion 41a or the curved portion 42 provided between the adjacent two LEDs on the flat circuit body 41 are not limited to one, and any number will do.

With the bent portion 41a or the curved portion 42 formed as depicted in Figs. 8A to 8D, the adjustment of the extra length of the flat circuit body 41 can be easily realized, workability of assembling the LED lighting device can be remarkably improved, considering the heat dissipation of the flat circuit body 41. Furthermore, the design change of the reflector 11 can be flexibly responded.

In case that the bent portion 41a is formed on the same side as the surface on which the LED is mounted as depicted in Fig. 8D, the bent portion 41a can be accommodated in the space outside the opening portion 13 of the reflector 11 (i.e., the space defining the outer portions of the adjacent engaging portions) as depicted in Fig. 2, thus the LED lighting device can be compacted as a whole.

Although various embodiments are described, the application of the present invention is not limited to the rear combination lamp of the automobile. The present invention is applicable to the room lamp. Furthermore, the LED lighting device of the invention can be applied not only to the lamp of the automobile, rail car or the other cars, but also the warning lamp and room lamp for vehicle, automatic barrier, road construction, and the illuminating device or the like.

The present specification is based on the Japanese Patent Application No. 2005-62146 filed on March 7, 2005, the entirety of which is incorporated herein by reference.

## Claims

1. An LED lighting device including a lamp housing formed by a lamp body and a lens installed in a front opening of the lamp body, a flat circuit body with a plurality of LEDs mounted thereon, and a reflector for reflecting lights generated by the LEDs, both of which are installed within said lamp housing,
wherein a plurality of opening portions are formed in a wall portion of said reflector, and said LEDs of the flat circuit body are fixed into the respective opening portions such that the flat circuit body is supported by the reflector.

2. The LED lighting device according to claim 1, wherein said reflector includes the wall portion positioned to face the lens, LED-fixing holes through which the respective LEDs of the flat circuit body are inserted, an engaging portion formed to be a tapered shape which defines the plurality of opening portions in the wall portion and communicates to the LED-fixing holes, each of the plurality of LEDs mounted on the flat circuit body being fixed onto the reflector in such manner that the LED is protruded through the LED-fixing hole into the opening portion defined by the engaging portion.

3. The LED lighting device according to claim 2, wherein a reflecting body is further arranged on a side of the engaging portion which faces the opening portion.

4. The LED lighting device according to claim 1, wherein said reflector includes the wall portion positioned to face the lens, an engaging portion formed to be a tapered shape which defines the plurality of opening portions in the wall portion, and a socket engaging portion to engage a socket in a lower end of the engaging portion, a socket receiving the LED and having a hole through which the light generated by the LED passes, being installed at a position of the flat circuit body on which the LED is mounted, and the socket being engaged in the socket engaging portion of the reflector, thus the LED of the flat circuit body is fixed in the opening portion of the reflector.

5. The LED lighting device according to claim 1 or 4,
wherein a bent portion is formed between the adjacent LEDs on the flat circuit body.

6. The LED lighting device according to claim 4, wherein the socket engaging portion of the reflector includes a ring-like engaging projection on an outer surface thereof, and the socket includes a ring-like engaged projection corresponding to the engaging projection, the engaging projection and the engaged projection being fitted so that the LED on the flat circuit body is fixed on the reflector.

7. The LED lighting device according to claim 6, wherein the socket comprises a box-like socket body receiving the LED, and a cover fixed to the socket body to hold the flat circuit body at a portion adjacent the LED together with the socket body, said hole portion being provided in the socket body so that an inner space of the socket body receiving the LED is communicated with the opening portion.
